# EUROPÄISCHE PATENTSCHRIFT

(11) **EP 1 188 176 B1**
(45) Veröffentlichungstag und Bekanntmachung des Hinweises auf die Patenterteilung: **13.12.2006**
(21) Anmeldenummer: 00982961.5
(22) Anmeldetag: 06.10.2000
(51) Int. Cl.: H01J 61/52

(54) **ENTLADUNGSLAMPE MIT TEMPERATURHOMOGENITÄT**
DISCHARGE LAMP HAVING AN IMPROVED TEMPERATURE HOMOGENEITY
LAMPE A DECHARGE PRESENTANT UNE HOMOGENEITE DE TEMPERATURE AMELIOREE

(30) Priorität: 16.11.1999 DE 19955108
(43) Veröffentlichungstag der Anmeldung: 20.03.2002
(73) Patentinhaber: Patent-Treuhand-Gesellschaft für elektrische Glühlampen mbH, 81543 München (DE)
(72) Erfinder: VOLLKOMMER, Frank, 82131 Buchendorf (DE); HITZSCHKE, Lothar, 81737 München (DE)
(86) Internationale Anmeldenummer: PCT/DE2000/003519
(87) Internationale Veröffentlichungsnummer: WO 2001/037318

(56) Entgegenhaltungen:
- WO-A-98/43276
- DE-C- 19 811 520
- US-A- 5 315 211
- PATENT ABSTRACTS OF JAPAN vol. 013, no. 192 (E-753), 9. Mai 1989 (1989-05-09) -& JP 01 014857 A (ORC MFG CO LTD), 19. Januar 1989 (1989-01-19)

## Beschreibung

### Technisches Gebiet

Diese Erfindung betrifft eine für dielektrisch behinderte Entladungen ausgelegte Entladungslampe. Eine solche Entladungslampe weist regelmäßig ein Entladungsgefäß auf, das das Entladungsmedium, gewöhnlich Xe, allgemeiner eine Gasmischung mit einem Edelgas, enthält. Zur Zündung und Aufrechterhaltung der Entladungen sind Elektroden vorgesehen, wobei sich für dielektrisch behinderte Entladungen ausgelegte Entladungslampen dadurch auszeichnen, daß zumindest die als Anoden ausgelegten Elektroden durch eine dielektrische Schicht, die auch eine Wand des Entladungsgefäßes sein kann, von dem Entladungsmedium getrennt sind. Es können auch alle Elektroden dielektrisch behindert sein, z.B. um die Entladungslampe für eine bipolare elektrische Versorgung geeignet zu machen.

### Stand der Technik

Die grundsätzlichen physikalischen Vorgänge, technischen Eigenheiten und Vorteile sowie Anwendungsmöglichkeiten in bzw. von Entladungslampen für dielektrisch behinderte Entladungen werden hier als bekannt vorausgesetzt. Es kann auf die einschlägige Literatur verwiesen werden.

Ein wesentliches Leistungsmerkmal für dielektrisch behinderte Entladungen ausgelegter, das heißt also sogenannte "stiller" Entladungslampen ist die zeitliche und örtliche Homogenität der Leuchtdichte. In diese Richtung zielten besondere Maßnahmen zur Beeinflussung der Verteilung der Entladung in dem Entladungsraum, insbesondere einzelner lokalisierbarer Entladungsstrukturen, durch besondere, Vorzugspunkte für die Entladungsstrukturen bildende Elektrodenstrukturen. Hierzu kann z.B. verwiesen werden auf die Patentanmeldung DE 19636965A1. Durch die Lokalisierung der Einzelentladungen durch Elektrodenstrukturen können im Hinblick auf die räumliche Anordnung optimierte Muster vorgegeben werden, die den Entladungsraum so ausfüllen, daß eine günstige Verteilung der Leuchtdichte entsteht. Es besteht jedoch weiterhin ein Bedürfnis nach Verbesserungen der zeitlichen und örtlichen Homogenität der Leuchtdichte, und zwar vor allem bei Entladungslampen mit nennenswerter Ausdehnung in zumindest einer Richtung, also beispielsweise stabförmigen Lampen mit einer Längserstreckungsrichtung und flächigen Lampen mit zwei solchen Richtungen.

### Darstellung der Erfindung

Der Erfindung liegt somit das technische Problem zugrunde, eine hinsichtlich der zeitlichen und örtlichen Homogenität der Leuchtdichte verbesserte stille Entladungslampe anzugeben.

Erfindungsgemäß wird dieses Problem gelöst durch eine Entladungslampe für dielektrisch behinderte Entladungen mit einem mit einem Entladungsmedium gefüllten Entladungsgefäß und Entladungselektroden, die zumindest teilweise durch eine dielektrische Schicht von dem Entladungsmedium getrennt sind, wobei das Entladungsgefäß zumindest entlang einer Längsrichtung ausgedehnt ist, gekennzeichnet durch eine thermische Einrichtung zur Steuerung des Wärmetransports in die/ aus der Lampe in entlang der Längsrichtung inhomogener Weise, die so ausgelegt ist, daß im Betrieb die Temperatur in der Lampe entlang der Längsrichtung homogenisiert wird.

Die Erfindung geht dabei von der Erkenntnis aus, daß Inhomogenitäten in ausgedehnten stillen Entladungslampen teilweise erst durch Zeitablauf im Betrieb entstehen. Dabei konnte auf einen Zusammenhang zwischen der Homogenität der Temperaturverteilung in dem Entladungsgefäß und der Homogenität der Lichtabstrahlung geschlossen werden. Offenbar hat, da in einem Entladungsgefäß ein homogen gleich verteilter Druck herrscht, eine Inhomogenität der Temperaturverteilung eine inhomogene Dichteverteilung des Entladungsmediums zur Folge. Die Dichte des Entladungsmediums beeinflußt wiederum die Entladungsphysik. In diesem Sinn ist offenbar eine durch die Einbausituation, durch die Konstruktion der Lampe selbst, durch äußere Temperaturinhomogenitäten oder andere Ursachen bewirkte Inhomogenität der Temperatur ursächlich für Leuchtdichteschwankungen über die zumindest eine Ausdehnungslängsrichtung der Lampe.

Insbesondere hat sich herausgestellt, daß sich diese Leuchtdichtevariationen mit der Betriebszeit herausbilden können, also über die rein örtliche Variation im allgemeinen mit einer zeitlichen Variation der Leuchtdichteverteilung in der Anfangsphase des Betriebs verknüpft sind. Damit ist die mangelnde Temperaturhomogenität also in zweifacher Hinsicht von Nachteil.

Das allgemeine erfinderische Konzept besteht darin, auf die Temperaturverteilung durch eine thermische Einrichtung in allgemeinsten Sinn Einfluß zu nehmen, die den Wärmetransport in die Lampe und/oder aus der Lampe steuert. Dabei handelt es sich erfindungsgemäß nicht einfach um beispielsweise eine leistungsfähige Kühleinrichtung, mit der man gewissermaßen versucht, durch eine entsprechend großzügige Auslegung der Kühlvorrichtung deren Temperaturhomogenität der Lampen aufzuprägen. Vielmehr geht die Erfindung davon aus, daß die thermische Einrichtung ihrerseits in inhomogener Weise auf den Wärmetransport Einfluß nimmt, und zwar in dem Temperatureigenverhalten der Lampe komplementär zugeordneter Weise. Damit soll der Ausbildung des inhomogenen Temperaturprofils in der Entladungslampe entgegengewirkt werden.

Die hier gebrauchte Bezeichnung "thermische Einrichtung" umfaßt grundsätzlich alle Maßnahmen, mit denen auf den Wärmetransport Einfluß genommen werden kann. Insbesondere sind dabei sowohl die Steuerung des Wärmetransports aus der Lampe nach außen als auch in umgekehrter Richtung zusammengefaßt. In Frage kommen also insbesondere Kühleinrichtungen im allgemeinsten Sinn, also Einrichtungen, die den Wärmeabtransport aus der Entladungslampe nach außen unterstützen und verbessern, Isolationseinrichtungen, also Einrichtungen, die den Wärmetransport reduzieren, wobei dies im allgemeinen den Wärmetransport aus der Entladungslampe nach außen meint, und schließlich auch Heizeinrichtungen.

In sehr vielen Fällen ist das Temperatureigenverhalten der Lampe, also das sich ohne erfindungsgemäße thermische Einrichtung einstellende inhomogene Temperaturprofil, dadurch gekennzeichnet, daß Randbereiche der Entladungslampe im Betrieb weniger stark erwärmt werden als mittlere Bereiche. Dies kann z.B. daran liegen, daß die Randbereiche bezogen auf den ihnen zugeordneten Teil des Entladungsraums eine größere Oberfläche und damit stärkere Wärmeverluste haben. Die Erfindung bezieht sich jedoch auch auf anders gelagerte Fälle, in denen z.B. durch besondere Montagesituationen, durch Nähe zu wärmeentwickelnden anderen Bauteilen, durch besondere Entladungsgefäßgeometrien oder anderweitig inhomogene Temperaturprofile entstehen.

Konkrete Möglichkeiten für erfindungsgemäße thermische Einrichtungen sind beispielsweise mit der Entladungslampe in thermischem Kontakt stehende Kühlkörper mit Kühlrippen, wobei das Vorhandensein der Kühlrippen, ihre Ausdehnung oder die Dichte ihrer Anordnung in auf das Eigentemperaturverhalten der Entladungslampe abgestimmter Weise inhomogen sind. Beispielsweise können die Kühlrippen nur in der Mitte der Lampe vorhanden sein oder in der Mitte der Lampe dichter liegen oder großflächiger ausgedehnt sein. Eine inhomogene Kühlung kann auch erfolgen durch eine Montageeinrichtung, die beispielsweise im mittleren Bereich der Entladungslampe gut wärmeleitfähig ankoppelt und durch eigene gute Wärmeleitfähigkeit als Kühleinrichtung wirkt. Beispielsweise kann es sich dabei um einen massiven Metallkörper handeln. Natürlich können diese beiden Lösungen auch kombiniert sein.

Eine andere Möglichkeit besteht darin, die Randbereiche einer Entladungslampe thermisch von der Außenwelt zu isolieren oder durch stärkere Ausführung ohnehin vorhandener Isolierungen oder anderer Bauteile mit isolierenden Eigenschaften, beispielsweise Entladungsgefäßwänden, für eine verstärkte Isolierung im Randbereich zu sorgen. Zu Einzelheiten dieser verschiedenen Möglichkeiten wird auf die Ausführungsbeispiele im weiteren Verlauf der Beschreibung verwiesen.

Im einleitenden Teil der Beschreibung wurden bereits konventionelle Maßnahmen erwähnt, mit denen auf die räumliche Verteilung von Einzelentladungsstrukturen Einfluß genommen werden kann. Wesentlich ist, daß sich die mit dieser Erfindung vorgeschlagenen Maßnahmen und diese konventionellen Möglichkeiten in keiner Weise gegenseitig ausschließen, sondern eher im Ergebnis unterstützen. Insoweit richtet sich die Erfindung insbesondere auf Entladungslampen, die für das von der Anmelderin entwickelte gepulste Betriebsverfahren ausgelegt sind. Dieses gepulste Betriebsverfahren sorgt für die Ausbildung lokalisierbarer Einzelentladungsstrukturen. Zu Einzelheiten kann auf den Stand der Technik verwiesen werden, und zwar insbesondere auf die WO 94/23442. Insbesondere richtet sich die Erfindung damit auch auf eine erfindungsgemäß ausgestaltete Entladungslampe mit einem für das gepulste Betriebsverfahren vorgesehenen Vorschaltgerät.

Ein wichtiger Anwendungsfall von stillen Entladungslampen sind solche mit stabförmig langgestrecktem Entladungsgefäß. Sie sind also nur in einer Längsrichtung ausgedehnt und in der dazu senkrechten Ebene im Querschnitt vergleichsweise klein. Wichtige Anwendungsfälle solcher "Linienstrahler" liegen beispielsweise im Bereich der Büroautomation (OA). Sie können in Scaneinrichtungen, beispielsweise in Faxgeräten, elektronischen Kopierern oder in der Computerperipherie eingesetzt werden. Gleichfalls eignen sie sich auch gut für konventionelle Fotokopiermaschinen. In diesem Zusammenhang ist festzuhalten, daß sich die Erfindung nicht nur auf Entladungslampen bezieht, die sichtbares Licht erzeugen, sondern beispielsweise auch auf UV-Strahler.

Im Bereich dieser Linienstrahler ist die Erfindung von besonderem Vorteil bei relativ leistungsstarken Linienstrahlern, bei denen die durch die Erfindung beseitigten oder zumindest gemilderten Nachteile erfahrungsgemäß verstärkt auftreten. Leistungsstarke Linienstrahler können beispielsweise Linienleistungsdichten von über 0,3W/cm haben.

Die Erfindung eignet sich aber auch gut für die Anwendung bei Flachstrahlern, also flächigen, im wesentlichen zweidimensional ausgedehnten Entladungslampen, z.B. für die Hinterleuchtung von Flüssigkristallbildschirmen. Auch bei solchen Flachstrahlern ist eine stärkere Kühlung eines Mittenbereichs gegenüber einem Randbereich oder bessere Isolierung des Randbereichs gegenüber dem Mittenbereich oder Heizung des Randbereichs, also eine thermische Einrichtung im Sinne der Erfindung, von Vorteil. Dazu können grundsätzlich die bereits ausgeführten Möglichkeiten gewählt werden, beispielsweise Kühlrippen, wobei die Kühlrippen nicht nur entlang der Längsrichtung, sondern auch der Querrichtung (in der Ebene des Flachstrahlers) entsprechend inhomogen angeordnet sind. Ein Beispiel hierzu ist Bestandteil der Ausführungsbeispiele, die weiter unten beschrieben werden.

Eine andere Möglichkeit, die ebenfalls bei den Ausführungsbeispielen illustriert ist, weist ein flächiges Blech auf, das mit dem Entladungsgefäß des Flachstrahlers in flächiger Weise in thermischem Kontakt steht. In dem Blech sind Aussparungen vorgesehen, durch die Stege definiert sind, die zumindest einen Mittenbereich des Blechs von einem Randbereich trennen, optional auch mehrere von dem Mittenbereich zu dem Randbereich hin gestufte Zwischenbereiche. Der Mittenbereich des Blechs kann gekühlt werden, indem er selbst als Kühleinrichtung ausgebildet ist, z.B. mit Kühlrippen, oder mit einer Kühleinrichtung in thermischem Kontakt steht. Durch die Stege ist eine Beeinflußung des Wärmetransports vom Randbereich in den gekühlten Mittenbereich möglich, so daß wiederum eine inhomogene Steuerung des Wärmetransports aus der Lampe in das Blech erfolgen kann. Der unmittelbar gekühlte Mittenbereich des Blechs wird die Lampe nämlich stärker kühlen als der oder die nur über die Stege damit in Verbindung stehende(n) äußere(n) Bereich(e).

### Beschreibung der Zeichnungen

Im folgenden wird die Erfindung anhand verschiedener Ausführungsbeispiele näher veranschaulicht. Dabei offenbarte Merkmale können auch einzeln oder in anderen als in dargestellten Kombinationen erfindungswesentlich sein. Im einzelnen zeigt:
- Figur 1: eine schematische Darstellung eines ersten Ausführungsbeispiels einer erfindungsgemäßen Entladungslampe;
- Figur 2: eine schematische Darstellung eines zweiten Ausführungsbeispiels einer erfindungsgemäßen Entladungslampe;
- Figur 3: einen Querschnitt durch die Entladungslampe aus Figur 2;
- Figur 4: eine schematische Darstellung eines dritten Ausführungsbeispiels einer erfindungsgemäßen Entladungslampe;
- Figur 5: einen Querschnitt durch die Entladungslampe aus Figur 4 im Randbereich;
- Figur 6: einen Querschnitt durch die Entladungslampe aus Figur 4 im Mittenbereich;
- Figur 7: eine schematische Draufsicht auf ein viertes Ausführungsbeispiel, nämlich einen erfindungsgemäßen Flachstrahler;
- Figuren 8A, 8B, 8C: Schnittdarstellungen durch das Ausführungsbeispiel aus Figur 7,
- Figur 9: ein fünftes Ausführungsbeispiel als Flachstrahler.

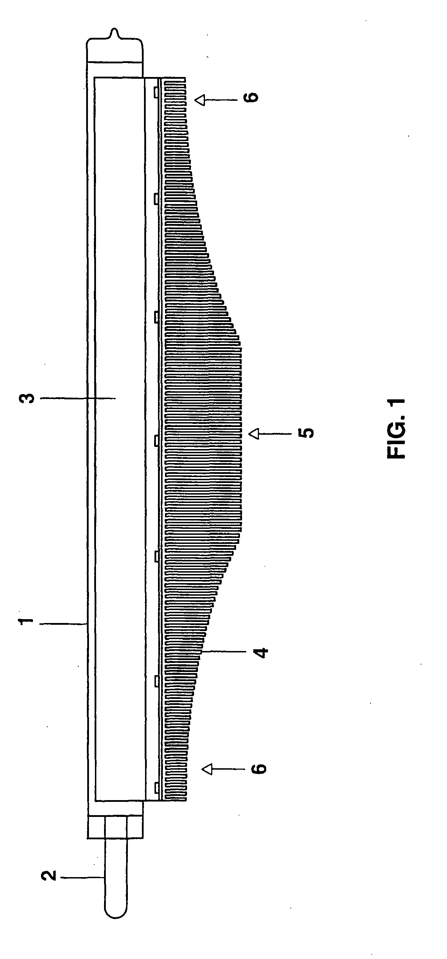

Figur 1 zeigt ein erstes Ausführungsbeispiel, eine erfindungsgemäße stille Entladungslampe, die im wesentlichen aus einem langgestreckten, einseitig verschlossenen Glasrohr 1 besteht, das an dem offenen Ende mit einem getrennten Stopfen 2 verschlossen ist. Zu dieser Lampe gehörige Einzelheiten bezüglich der Elektrodenstruktur, Leuchtstoffbeschichtung und dergleichen werden hier nicht erläutert, weil sie für die Erfindung nicht wesentlich sind. Ergänzend wird jedoch verwiesen auf die DE 197 18 395. Natürlich können statt der in diesem Dokument gezeigten innenliegenden Elektroden auch eine oder mehrere außenliegende verwendet werden.

Entlang der in Figur 1 der horizontalen Erstreckung entsprechenden Längsrichtung soll eine möglichst homogene Leuchtdichte der Entladungslampe erzielt werden. Erfindungsgemäß wird dies unterstützt durch einen Kühlkörper 3, der praktisch entlang der gesamten Länge der Lampe wärmeleitfähig mit dieser verbunden ist, d.h. flächig anliegt, angeklemmt ist oder angeklebt ist. Der Kühlkörper 3 weist eine Vielzahl senkrecht zur Längsrichtung orientierte, Kühlflächen bildende Rippen 4 auf, die parallel zueinander gestaffelt sind. Dabei sind die Kühlrippen 4 in einem äußeren Randbereich 6 in der Umgebung des linken und des rechten Endes der Entladungslampe relativ klein bemessen, d.h. ragen von dem lampennahen Basisteil des Kühlkörpers 3 nur wenig weg. In einem Mittenbereich 5, der dem Zentrum der Lampe entspricht, sind die Kühlrippen 4 hingegen sehr viel länger ausgebildet und zeigen daher eine deutlich stärkere Kühlwirkung. Zwischen dem Mittenbereich 5 und dem Randbereich 6 sind fließende Übergänge der Kühlrippenlänge vorgesehen.

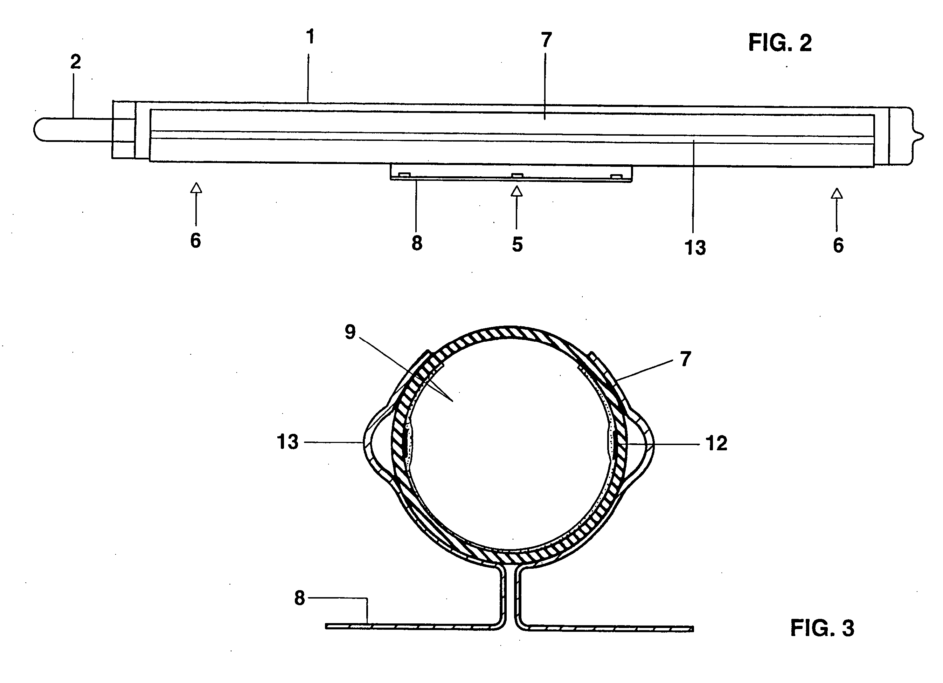

Als Alternative dazu zeigt Figur 2 ein zweites Ausführungsbeispiel, bei dem eine der Darstellung der Figur 1 entsprechende Entladungslampe mit einer metallischen Schale 7 versehen ist, die wiederum in gutem Wärmekontakt zu der Entladungslampe steht. Figur 3 zeigt einen Querschnitt durch die Darstellung in Figur 2 mit bezüglich Figur 2 horizontaler Blickrichtung, und zwar durch den mittleren Bereich 5 in Figur 2. Man erkennt, daß die metallische Schale 7 die Entladungslampe beiderseits umfaßt, wobei etwa das obere Drittel der im Querschnitt kreisförmigen Entladungslampe zur Lichtabstrahlung frei bleibt. Dementsprechend ist im Inneren der Entladungslampe eine der Umschließung durch die Schale 7 entsprechende Reflexionsschicht 9 vorgesehen vgl. die bereits zitierte DE 19718 395.

In Figur 3 ist im Querschnitt zu erkennen, daß zwischen der Reflexionsschicht 9 und dem Glasrohr 1 einander gegenüberliegende Elektrodenstreifen 12 vorgesehen sind, die bezüglich der Öffnung der Lampe im oberen Drittel symmetrisch liegen. An diesen Stellen ist zwischen der Schale 7 und dem Glasrohr 1 ein Abstand vorgesehen, in dem die Schale 7 in einer etwas ausgewölbten Form 13 im Bereich der Elektrodenstreifen 12 mit Abstand zum dem Glasrohr 1 verläuft. Etwas oberhalb und etwas unterhalb der Elektrodenstreifen 12 liegt die Schale 7 jedoch wieder an dem Glasrohr 1 an. Diese Struktur hat den Vorteil einer geringeren kapazitiven Kopplung zwischen der Schale 7 und den Elektrodenstreifen 12. Sie ist für die thermischen Eigenschaften nicht von wesentlicher Bedeutung, da im übrigen Bereich der Schale 7 ein guter thermischer Kontakt zu dem Lampenrohr 1 vorliegt. Auch die übrigen Ausführungsbeispiele können vergleichbare Strukturen aufweisen, was nicht näher dargestellt ist.

Die metallische Schale 7 weist im mittleren Bereich 5 einen Fuß 8 auf, der wiederum gut wärmeleitfähig an einer hier nicht weiter interessierenden Basis montiert ist, die jedoch als Wärmesenke bzw. Wärmepuffer dienen kann. Dadurch führt der Fuß 8 im mittleren Bereich 5 in stärkerem Maße Wärme aus der Schale 7 und damit aus der Entladungslampe ab, als dies in dem Randbereich 6 der Fall ist, in dem kein Fuß vorhanden ist. Die Schale 7 mit dem Fuß 8 im Mittenbereich 5 bildet also eine entlang der horizontalen Längserstreckung der Entladungslampe inhomogen wirkende Kühleinrichtung, wie das auch bei dem ersten Ausführungsbeispiel der Fall ist.

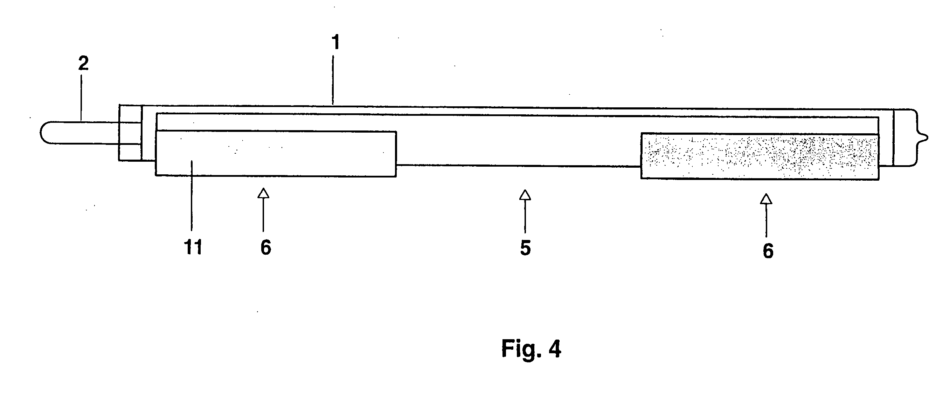

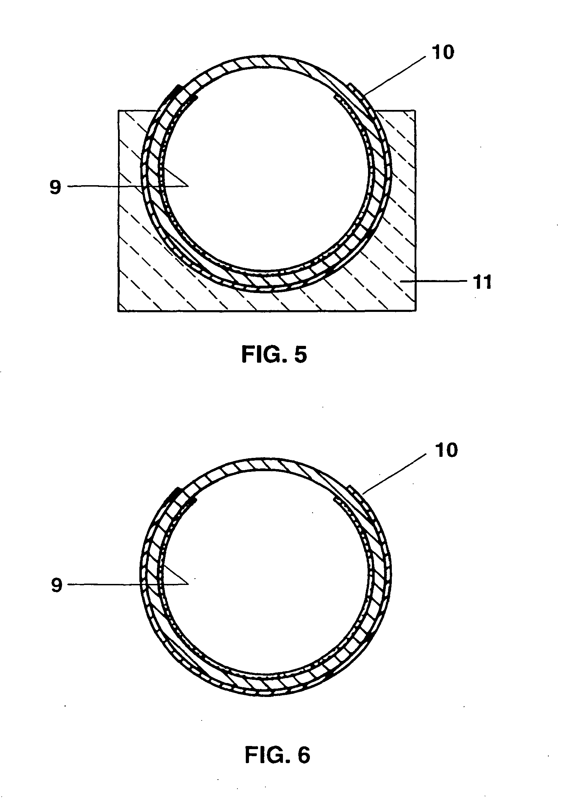

Ein weiteres Beispiel zeigen die Figuren 4, 5 und 6. Figur 5 zeigt dabei einen Figur 3 in der Perspektive entsprechenden Schnitt, jedoch durch einen Randbereich 6 in Figur 4, wohingegen Figur 6 einen entsprechenden Schnitt durch den Mittenbereich 5 darstellt. Man erkennt, daß wiederum eine metallische Schale 10 in gutem Wärmekontakt mit der Entladungslampe vorgesehen ist, die jedoch in diesem Fall nicht als Kühleinrichtung, sondern lediglich als Abschirmung der elektromagnetischen Strahlung aus der Entladungslampe dient. Diese Funktion ist übrigens auch der metallischen Schale 7 aus Figur 2 zu eigen. In beiden Fällen sind die Schalen 7 und 10 dazu vorzugsweise geerdet. Bei dem in Figur 4 dargestellten dritten Ausführungsbeispiel ist im Randbereich 6 jedoch um die Schale 10 herum eine zusätzliche thermische Isolierung 11 vorgesehen, so daß der Mittenbereich 5 die Verlustwärme der Entladung besser nach außen abführen kann als der Randbereich 6. Dieses dritte Ausführungsbeispiel zeigt also eine erfindungsgemäße thermische Einrichtung im Sinn einer entlang der Längsrichtung inhomogenen Isolierung der Entladungslampe.

Natürlich können die in den Ausführungsbeispielen dargestellten Lösungen auch kombiniert sein, beispielsweise eine Isolierung nach dem dritten Ausführungsbeispiel mit einer Kühlung nach dem ersten oder zweiten Ausführungsbeispiel. Allen drei Fällen gemeinsam ist, daß die Temperaturhomogenität in der Längsrichtung des Linienstrahlers deutlich verbessert wird. Wegen der bei gleichem Druck und weitgehend homogener Temperatur dann weitgehend homogenen Gasdichte innerhalb der Entladungslampe wird somit auch eine sehr homogene Leuchtdichteverteilung realisiert.

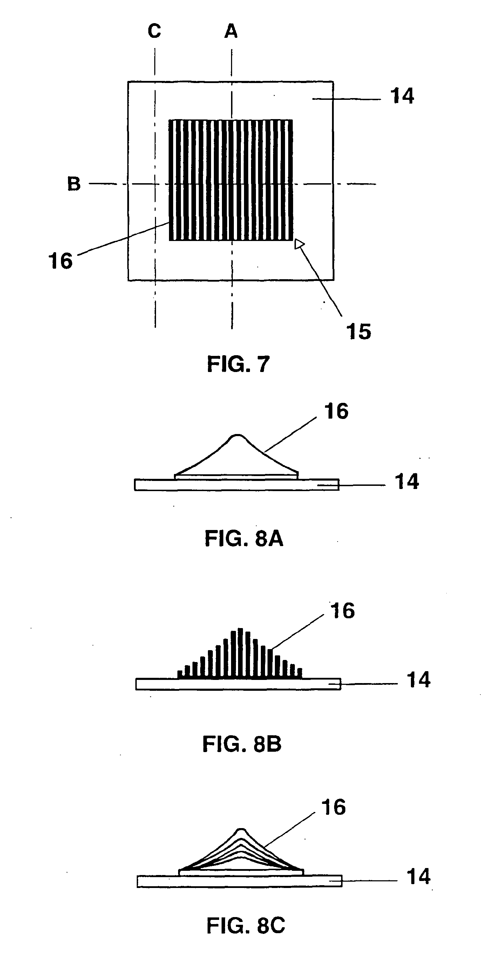

Figur 7 zeigt schematisch ein Ausführungsbeispiel in Form eines Flachstrahlers 14. Der Flachstrahler 14 ist hier nur als flache zweidimensional ausgedehnte Platte dargestellt, weil er dem Fachmann in seinen technischen Einzelheiten aus dem Stand der Technik geläufig ist. Es kann z.B. verwiesen werden auf die WO98/43276.

Auf dem Flachstrahler 14 ist an der der Lichtabstrahlungsseite entgegengesetzten flachen Seite ein Kühlkörper 15 angebracht, der den mittleren Bereich des Flachstrahlers abdeckt. Die Figuren 8A, 8B, 8C zeigen, wie in Figur 7 angedeutet, einen Schnitt durch den Flachstrahler 14 und den Kühlkörper 15 aus Figur 7 entlang der Linie A bzw. B bzw. C (mit Seitenansicht des Kühlkörpers 15). Man erkennt, daß der Kühlkörper wie bei den Ausführungsbeispielen aus Figur 1 Kühlrippen 16 aufweist, die sich voneinander parallel beabstandet erstrecken. Dabei sind die Kühlrippen 16 so gestaltet, daß sie im mittleren Bereich des Kühlkörpers 15 am höchsten verlaufen. Hierzu haben sie ein von beiden Enden zu einem mittleren Maximum hochlaufendes Profil, wobei die mittleren Maxima der Kühlrippen so gestaffelt sind, daß das Profil einer einzelnen Kühlrippe 16 aus Figur 8 A im wesentlichen einer Einhüllenden über die in Figur 8 B sichtbaren Maxima der Gesamtzahl der Kühlrippen 16 entspricht. Insgesamt ergibt sich hiermit eine durch die Gestaltung der Kühlrippen 16 und durch die mittige, den Rand nicht erfassende Anordnung des Kühlkörpers 15 bewirkte Inhomogenität der Kühlwirkung mit Schwerpunkt in der Mitte des Flachstrahlers 14.

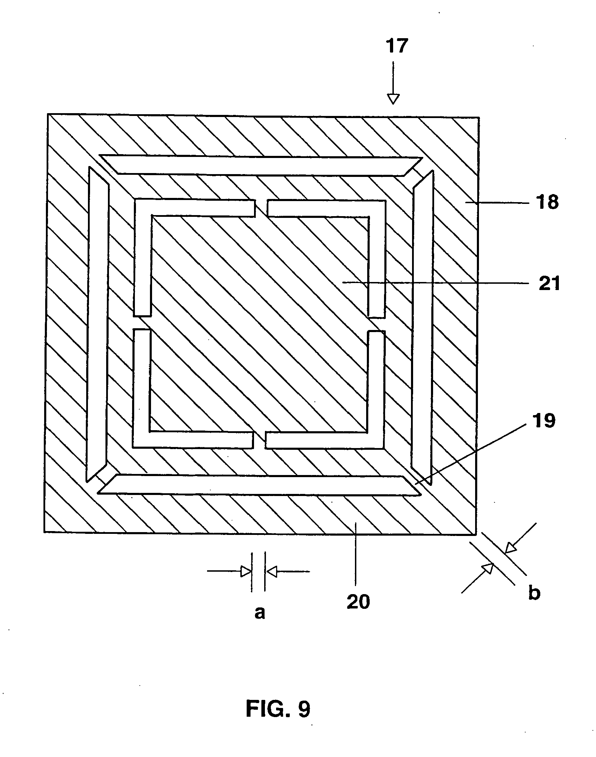

Figur 9 zeigt schließlich ein letztes Ausführungsbeispiel, das sich ebenfalls auf einen Flachstrahler bezieht. Der Flachstrahler ist nur schematisch dargestellt und insgesamt mit der Bezugsziffer 17 bezeichnet. In gutem flächigem Wärmekontakt mit einem nicht näher dargestellten Entladungsgefäß des Flachstrahlers 17 steht ein der Fläche des Entladungsgefäßes weitgehend entsprechendes Blech 18, das in Figur 9 näher dargestellte Aussparungen aufweist. Durch die Aussparungen sind verschiedene Stege 19 gebildet, die einen Mittenbereich 21 des Blechs 18 mit einem Randbereich 20 verbinden. In Figur 9 ist zwischen dem Mittenbereich 21 und dem Randbereich 20 noch ein Zwischenbereich vorgesehen, der jedoch nicht unbedingt notwendig ist. Durch einen solchen Zwischenbereich oder auch mehrere Zwischenbereiche kann die Inhomogenität der thermischen Beeinflussung der Entladungslampe gleichmäßiger gestaltet werden.

Der Mittenbereich 21 steht mit einer nicht mehr dargestellten Kühleinrichtung in Kontakt, beispielsweise mit Kühlrippen. Durch den durch die Stegform des Blechs 18 eingeschränkten Wärmetransport zwischen dem Mittenbereich 21 und dem Randbereich 20 wird damit der Mittenbereich 21 sehr viel stärker gekühlt als der nur mittelbar gekühlte Randbereich 20. Der Zwischenbereich nimmt dabei natürlich eine Zwischenstellung ein.

Eine Steuerung dieses Wärmetransports kann dabei durch die Zahl und die Ausdehnung, in Figur 9 mit a und b bezeichnet, der Stege folgen.

Auch diese Ausführungsform kann, wie alle anderen Ausführungsformen auch, eine Funktion als Abschirmung elektromagnetischer Strahlung aus der Lampe ausfüllen oder mit einer solchen Abschirmung kombiniert sein.

Bei den hier dargestellten Ausführungsbeispielen zeigte sich keine relevante Abhängigkeit der Leuchtdichte von der Temperatur, solange die Temperaturvariationen im typischen Bereich einiger 10 Kelvin lagen. Tatsächlich ergeben sich daraus thermische Energien, die im Vergleich zu den für die Entladungsphysik maßgeblichen Energien nicht ins Gewicht fallen sollten. Solange sich durch das Entstehen einer Inhomogenität der Gasdichte keine heterogene Entladungssituation ergibt, kann damit nicht nur die örtliche Homogenität verbessert, sondern auch das zeitliche Anlaufverhalten praktisch vermieden werden.

Insbesondere bei den hier dargestellten Linienstrahlern ist es zudem möglich, daß sich abhängig von der Betriebslage, also vor allem im vertikalen Betrieb mit zusätzlicher vertikaler Temperaturinhomogenität, eine Situation ergibt, in der ohne die Erfindung die Zündbedingungen innerhalb eines leistungsstarken langgestreckten Linienstrahlers so inhomogen werden, daß die Entladungen nur noch in den Bereichen mit der niedrigeren Gasdichte und damit in größeren freien Weglängen brennen. Da in diesen Bereichen dann auch die Verlustwärme konzentriert ist, hat dieser Mechanismus einen selbstverstärkenden Charakter. Die Erfindung bietet hier wirksame Abhilfe.

## Patentansprüche

1. Entladungslampe für dielektrisch behinderte Entladungen mit einem
mit einem Entladungsmedium gefüllten Entladungsgefäß (1, 2) und Entladungselektroden, die zumindest teilweise durch eine dielektrische Schicht von dem Entladungsmedium getrennt sind,
wobei das Entladungsgefäß (1, 2) zumindest entlang einer Längsrichtung ausgedehnt ist,
**gekennzeichnet durch** eine thermische Einrichtung (3, 4, 7, 8, 10, 11) zur Steuerung des Wärmetransports in die/aus der Lampe in entlang der Längsrichtung inhomogener Weise,
die so ausgelegt ist, daß im Betrieb die Temperatur in der Lampe entlang der Längsrichtung homogenisiert wird.

2. Entladungslampe nach Anspruch 1, bei der die Inhomogenität einen Mittenbereich (5) der Entladungslampe von einem Randbereich (6) unterscheidet.

3. Entladungslampe nach Anspruch 1 oder 2, bei der die thermische Einrichtung (3, 4, 7, 8,10,11) eine Kühleinrichtung (3, 4, 7, 8) aufweist.

4. Entladungslampe nach Anspruch 3, bei der Kühlrippen (4) vorgesehen sind, die entlang der Längsrichtung hinsichtlich ihres Vorhandenseins, ihrer Ausdehnung und/oder ihrer Dichte inhomogen angeordnet sind.

5. Entladungslampe nach Anspruch 2 in Verbindung mit Anspruch 3 oder 4 mit einer Montageeinrichtung (8), die in gut wärmeleitfähiger Weise an den Mittenbereich (5) gekoppelt ist.

6. Entladungslampe nach einem der vorstehenden Ansprüche, bei der die thermische Einrichtung (10,11) eine Isolationseinrichtung (11) aufweist.

7. Entladungslampe nach Anspruch 2 und 6, bei der der Randbereich (6) thermisch isoliert ist.

8. Entladungslampe nach einem der vorstehenden Ansprüche, bei der die thermische Einrichtung eine Heizeinrichtung aufweist.

9. Entladungslampe nach einem der vorstehenden Ansprüche mit einem für ein gepulstes Betriebsverfahren ausgelegten Vorschaltgerät.

10. Entladungslampe nach einem der vorstehenden Ansprüche, bei der die Entladungselektroden Strukturen zur Festlegung des Orts von Einzelentladungen aufweisen.

11. Entladungslampe nach einem der vorstehenden Ansprüche, bei der das Entladungsgefäß (1, 2) stabförmig langgestreckt ist.

12. Entladungslampe nach Anspruch 11, die für eine Linienleistungsdichte entlang der Längsrichtung von 0,3W/cm oder mehr ausgelegt ist.

13. Entladungslampe nach Anspruch 11 oder 12, die für eine Kopiereinrichtung oder eine Scan-Einrichtung ausgelegt ist.

14. Entladungslampe nach einem der vorstehenden Ansprüche, die als Flachstrahler (14,17) ausgebildet ist.

15. Entladungslampe nach Anspruch 14, bei der ein mit dem Entladungsgefäß in flächigem thermischen Kontakt stehendes Blech (18) Stege (19) definierende Aussparungen aufweist und ein über die Stege (19) mit einem Randbereich (20) des Blechs (18) verbundener Mittenbereich (21) eine Kühleinrichtung aufweist oder mit einer Kühleinrichtung verbunden ist.

## Claims

1. Discharge lamp for dielectric barrier discharges having a discharge vessel (1, 2) filled with a discharge medium and discharge electrodes, which are isolated at least partially from the discharge medium by a dielectric layer,
the discharge vessel (1, 2) extending along at least one longitudinal direction,
**characterized by** a thermal device (3, 4, 7, 8, 10, 11) for controlling the heat transfer into/out of the lamp in an inhomogeneous manner along the longitudinal direction,
which is designed so that the temperature in the lamp is homogenized along the longitudinal direction during operation.

2. Discharge lamp according to Claim 1, in which the inhomogeneity differentiates a centre region (5) of the discharge lamp from an edge region (6).

3. Discharge lamp according to Claim 1 or 2, in which the thermal device (3, 4, 7, 8, 10, 11) comprises a cooling device (3, 4, 7, 8).

4. Discharge lamp according to Claim 3, in which cooling fins (4) are provided, which are arranged inhomogeneously as regards their presence, their length and/or their density along the longitudinal direction.

5. Discharge lamp according to Claim 2 in conjunction with Claim 3 or 4, having a mounting device (8) that makes good thermal contact with the centre region (5).

6. Discharge lamp according to any of the preceding claims, in which the thermal device (10, 11) comprises an insulating device (11).

7. Discharge lamp according to Claim 2 and 6, in which the edge region (6) is thermally insulated.

8. Discharge lamp according to any of the preceding claims, in which the thermal device comprises a heating device.

9. Discharge lamp according to any of the preceding claims, having a ballast designed for a pulsed operating method.

10. Discharge lamp according to any of the preceding claims, in which the discharge electrodes have structures for defining the location of individual discharges.

11. Discharge lamp according to any of the preceding claims, in which the discharge vessel (1, 2) is linearly extended.

12. Discharge lamp according to Claim 11, which is designed for a linear power density of 0.3 W/cm or more along the longitudinal direction.

13. Discharge lamp according to Claim 11 or 12, which is designed for a copier or a scanning device.

14. Discharge lamp according to any of the preceding claims, which is designed as a flat emitter (14, 17).

15. Discharge lamp according to Claim 14, in which a plate (18) in thermal contact with the discharge vessel over a planar surface comprises cut-outs that define webs (19), and a centre region (21) connected to an edge region (20) of the plate (18) via the webs (19) comprises a cooling device or is connected to a cooling device.

## Revendications

1. Lampe à décharge pour des décharges rendues incomplètes par voie diélectrique, comprenant une enceinte (1, 2) de décharge emplie d'un milieu de décharge et des électrodes de décharge, qui sont séparées au moins en partie du milieu de décharge par une couche diélectrique,
l'enceinte (1, 2) de décharge s'étendant au moins le long d'une direction longitudinale,
**caractérisée par** un dispositif (3, 4, 7, 8, 10, 11) thermique de commande du transport de la chaleur dans la lampe et hors de celle-ci de façon non homogène dans la direction longitudinale,
qui est tel qu'en fonctionnement la température dans la lampe est homogénéisée le long de la direction longitudinale.

2. Lampe à décharge suivant la revendication 1, dans laquelle le manque d'homogénéité d'une partie (5) médiane de la lampe à décharge est différent de celui d'une partie (6) marginale.

3. Lampe à décharge suivant la revendication 1 ou 2, dans laquelle le dispositif (3, 4, 7, 8, 10, 11) thermique comprend un dispositif (3, 4, 7, 8) de refroidissement.

4. Lampe à décharge suivant la revendication 3, dans laquelle il est prévu des ailettes (4) de refroidissement dont la présence, l'étendue et/ou la densité ne sont pas homogènes le long de la direction longitudinale.

5. Lampe à décharge suivant la revendication 2 en liaison avec la revendication 3 ou 4 comprenant un dispositif (8) de montage, qui est couplé d'une manière bonne conductrice de la chaleur à la partie (5) médiane.

6. Lampe à décharge suivant l'une des revendications précédentes, dans laquelle le dispositif (10, 11) thermique comporte un dispositif (11) isolant.

7. Lampe à décharge suivant la revendication 2 et 6, dans laquelle la partie (6) marginale est isolée thermiquement.

8. Lampe à décharge suivant l'une des revendications précédentes, dans laquelle le dispositif thermique comporte un dispositif de chauffage.

9. Lampe à décharge suivant l'une des revendications précédentes ayant un ballast conçu pour un procédé de fonctionnement pulsé.

10. Lampe à décharge suivant l'une des revendications précédentes, dans laquelle les électrodes de décharge ont des structures de fixation de l'emplacement de décharges individuelles.

11. Lampe à décharge suivant l'une des revendications précédentes, dans laquelle l'enceinte (1, 2) de décharge s'étend en longueur en forme de barreau.

12. Lampe à décharge suivant la revendication 11, qui est conçue pour une densité de puissance linéaire le long de la direction longitudinale supérieure ou égale à 0,3 W/cm.

13. Lampe à décharge suivant la revendication 11 ou 12, qui est conçue pour un dispositif de copiage ou pour un dispositif de balayage.

14. Lampe à décharge suivant l'une des revendications précédentes, qui est conçue sous la forme d'une source (14, 17) de rayonnement plate.

15. Lampe à décharge suivant la revendication 14, dans laquelle une tôle (18) en contact thermique suivant une surface avec l'enceinte de décharge a des évidements définissant des parties pleines (19) et une partie (21) médiane reliée par les parties pleines (19) à une partie (20) marginale de la tôle (18) à un dispositif de refroidissement ou est reliée à un dispositif de refroidissement.
